# EUROPEAN PATENT APPLICATION

(11) **EP 4 716 390 A1**
(43) Date of publication of application: **25.03.2026**
(21) Application number: 24811237.7
(22) Date of filing: 25.03.2024
(51) Int. Cl.: H05K 7/20, H05K 9/00, G06F 1/20

(54) **ELECTRONIC DEVICE COMPRISING HEAT DISSIPATION STRUCTURE**

(30) Priority: 22.05.2023 KR 20230065708; 15.06.2023 KR 20230076737
(71) Applicant: Samsung Electronics Co., Ltd., Suwon-si, Gyeonggi-do 16677 (KR)
(72) Inventor: KWON, Ohhyuck, Suwon-si Gyeonggi-do 16677 (KR); PARK, Min, Suwon-si Gyeonggi-do 16677 (KR); SUNG, Jungoh, Suwon-si Gyeonggi-do 16677 (KR); SON, Changjong, Suwon-si Gyeonggi-do 16677 (KR); HWANG, Jieun, Suwon-si Gyeonggi-do 16677 (KR)
(74) Representative: Gulde & Partner
(86) International application number: PCT/KR2024/003711
(87) International publication number: WO 2024/242298

(57) **Abstract**

An electronic device according to an embodiment of the present disclosure comprises: a first support member at least partially comprising a thermally conductive material; a printed circuit board arranged to face the first support member; an integrated circuit chip arranged between the first support member and the printed circuit board, arranged on one surface of the printed circuit board, and equipped with a processor; a solid-state thermal interface material (TIM) with compressibility, of which at least a portion of one surface is in contact with the integrated circuit chip and at least a portion of the other surface is in contact with the first support member, to transfer heat between the integrated circuit chip and the first support member; and a shielding film which is arranged between the TIM and the first support member and partially attached to the TIM and provides a first opening allowing a portion of the other surface of the TIM to be attached to the first support member. In an embodiment, the TIM comprises a first portion that is in contact with the integrated circuit chip and a second portion laterally protruding from the first portion. In an embodiment, the second portion is at least partially attached to the shielding film. Other various embodiments are possible.

## Description

### [Technical Field]

One or more embodiments of the disclosure relate to an electronic device, and, for example, to an electronic device including a heat dissipation structure configured to transfer, distribute, and/or dissipate heat generated inside.

### [Background Art]

Typically, an electronic device means a device that performs a specific function according to a program incorporated therein, such as an electronic scheduler, a portable multimedia reproducer, a mobile communication terminal, a tablet PC, an image/sound device, a desktop/laptop PC, or a vehicle navigation system, as well as a home appliance. The above-mentioned electronic devices may output, for example, information stored therein as audio or video. As the integration density of electronic devices increases and ultra-high-speed, large-capacity wireless communication becomes common, various functions have recently been mounted on a single mobile communication terminal. For example, not only communication functions but also entertainment functions such as gaming, multimedia functions such as music and video playback, communication and security functions such as mobile banking, as well as schedule management and electronic wallet functions, are being integrated into a single electronic device.

As the performance of electric elements equipped with, for example, processors and communication modules, such as integrated circuit chips, has dramatically improved, an environment that allows various functions to be integrated into a single electronic device has been provided. The improvement in the performance of electric elements not only provides an environment that allows various functions to be incorporated into a single electronic device but also enhances data communication and processing speeds.

The above-described information may be provided as related art for the purpose of helping to understand the disclosure. No claim or determination is made regarding whether any of the foregoing may be applied as prior art with respect to the disclosure.

### [Detailed Description of the Invention]

### [Technical Solution]

According to an embodiment of the disclosure, an electronic device includes a first support member including, at least in part, a thermally conductive material, a printed circuit board disposed to face the first support member, an integrated circuit chip provided with a processor and disposed on one surface of the printed circuit board between the first support member and the printed circuit board, a compressible solid-state thermal interface material (TIM) having one surface, at least a portion of which is in contact with the integrated circuit chip and the other surface at least a portion of which is in contact with the first support member, the thermal interface material being configured to transfer heat between the integrated circuit chip and the first support member, and a shielding film partially attached to the thermal interface material between the thermal interface material and the first support member and providing a first opening configured to allow a portion of the other surface of the thermal interface material to be attached to the first support member. In an embodiment, the thermal interface material includes a first portion in contact with the integrated circuit chip and a second portion laterally protruding from the first portion. In an embodiment, the second portion is at least partially attached to the shielding film.

According to an embodiment of the disclosure, an electronic device includes a housing having a first surface and a second surface facing in a direction opposite to the first surface, a first support member accommodated in a space between the first surface and the second surface and including, at least in part, a thermally conductive material, a display disposed between the first surface and the first support member, a printed circuit board disposed between the second surface and the first support member, an integrated circuit chip disposed on one surface of the printed circuit board between the first support member and the printed circuit board and provided with a processor and memory, a compressible solid-state thermal interface material (TIM) having one surface at least a portion of which is in contact with the integrated circuit chip and the other surface at least a portion of which is in contact with the first support member, the thermal interface material being configured to transfer heat between the processor and the first support member or between the memory and the first support member, and a shielding film partially attached to the thermal interface material between the thermal interface material and the first support member and providing a first opening configured to allow a portion of the other surface of the thermal interface material to be attached to the first support member. In an embodiment, the thermal interface material includes a first portion in contact with the integrated circuit chip and a second portion laterally protruding from the first portion. In an embodiment, the second portion may be at least partially attached to the shielding film.

### [Brief Description of Drawings]

The above-described aspects or other aspects, configurations, and/or advantages regarding an embodiment of the disclosure may become more apparent through the following detailed description made with reference to the accompanying drawings.
FIG. 1 is a block diagram illustrating an electronic device according to an embodiment of the disclosure within a network environment.
FIG. 2 is a front perspective view of an electronic device according to an embodiment of the disclosure.
FIG. 3 is a rear perspective view of the electronic device according to an embodiment of the disclosure illustrated in FIG. 2.
FIG. 4 is an exploded perspective view illustrating a front side of the electronic device of FIG. 2, according to an embodiment of the disclosure.
FIG. 5 is an exploded perspective view illustrating a rear side of the electronic device of FIG. 2, according to an embodiment of the disclosure.
FIG. 6 is a view illustrating a heat dissipation structure of an electronic device according to an embodiment of the disclosure.
FIG. 7 is a view illustrating a shielding film in a heat dissipation structure of an electronic device according to an embodiment of the disclosure.
FIG. 8 is a view illustrating a state in which a thermal interface material is disposed on a shielding film in a heat dissipation structure of an electronic device according to an embodiment of the disclosure.
FIG. 9 is a view illustrating a heat dissipation structure of an electronic device according to an embodiment of the disclosure.
FIGS. 10 to 13 are views illustrating one or more configurations in which adhesives are provided on a shielding film in a heat dissipation structure of an electronic device according to an embodiment of the disclosure.
FIGS. 14 and 15 are views illustrating one or more configurations in which a shielding film is disposed in a heat dissipation structure of an electronic device according to an embodiment of the disclosure.

Throughout the appended drawings, like reference numerals may be assigned to like components, configurations, and/or structures.

### [Mode for Carrying out the Invention]

Heat generated from electric elements such as integrated circuit chips may hinder the operating environment of an electronic device. As the performance of various electric elements improves and the integration density of electronic devices increases, and/or as the capacity of image or audio data increases, the issue of operating environments being hindered by heat generation may become more severe. An integrated circuit chip equipped with a circuit device such as a processor may generate more heat than other electric elements. When more heat is generated in a narrow region and/or when the generated heat accumulates inside the electronic device, the operating environment of the electric elements may become even harsher.

An embodiment of the disclosure aims to at least resolve the above-described problems and/or disadvantages and to provide at least provide the advantages described below, and may provide an electronic device including a heat dissipation structure configured to rapidly transfer, disperse, or dissipate heat generated inside.

An embodiment of the disclosure may provide an electronic device including a heat dissipation structure configured to create a favorable operating environment by transferring, dispersing, or dissipating heat generated in a narrow region.

The technical issues to be addressed by the disclosure are not limited to those described above, and other technical issues may be clearly understood by a person ordinarily skilled in the related art to which the disclosure pertains.

The following description with reference to the appended drawings may provide an understanding of various exemplary implementations of the disclosure, including the claims and their equivalents. An exemplary embodiment disclosed in the following description includes various specific details to help understanding, but is considered to be one of various exemplary embodiments. Accordingly, it will be understood by a person ordinarily skilled in the art that various implementations described herein may be variously changed and modified without departing from the scope and spirit of the disclosure. In addition, descriptions of well-known functions and configurations may be omitted for clarity and brevity.

The terms and words used in the following description and claims are not limited to a bibliographical meaning, but may be used to describe an embodiment of the disclosure clearly and consistently. Accordingly, it will be apparent to those skilled in the art that the following description of various implementations of the disclosure is provided for explanatory purposes and not intended to limit the scope of the disclosure and equivalents thereof.

Unless the context clearly indicates otherwise, the singular forms of "a," "an," and "the" should be understood to include the plural meaning. Accordingly, for example, the term "a component surface" may be understood to include one or more surfaces of the component.

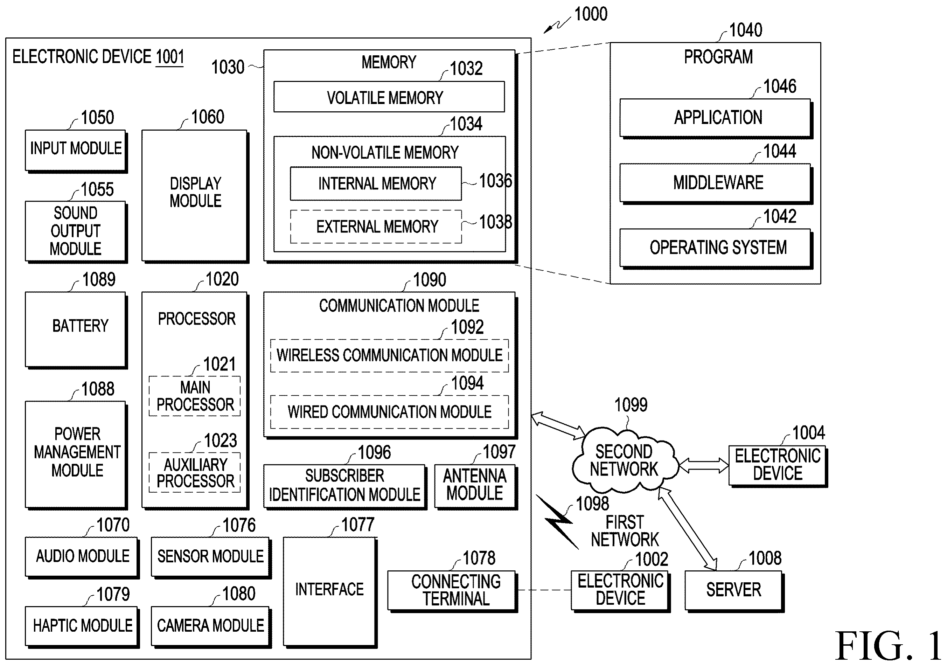

FIG. 1 is a block diagram illustrating an electronic device 1001 in a network environment 1000 according to an embodiment of the disclosure. Referring to FIG. 1, the electronic device 1001 in the network environment 1000 may communicate with an electronic device 1002 via a first network 1098 (e.g., a short-range wireless communication network), or at least one of an electronic device 1004 or a server 1008 via a second network 1099 (e.g., a long-range wireless communication network). According to an embodiment, the electronic device 1001 may communicate with the electronic device 1004 via the server 1008. According to an embodiment, the electronic device 1001 may include a processor 1020, memory 1030, an input module 1050, a sound output module 1055, a display module 1060, an audio module 1070, a sensor module 1076, an interface 1077, a connecting terminal 1078, a haptic module 1079, a camera module 1080, a power management module 1088, a battery 1089, a communication module 1090, a subscriber identification module (SIM) 1096, or an antenna module 1097. In some embodiments, at least one of the components (e.g., the connecting terminal 1078) may be omitted from the electronic device 1001, or one or more other components may be added in the electronic device 1001. In some embodiments, some of the components (e.g., the sensor module 1076, the camera module 1080, or the antenna module 1097) may be implemented as a single component (e.g., the display module 1060).

The processor 1020 may execute, for example, software (e.g., a program 1040) to control at least one other component (e.g., a hardware or software component) of the electronic device 1001 coupled with the processor 1020, and may perform various data processing or computation. According to one embodiment, as at least part of the data processing or computation, the processor 1020 may store a command or data received from another component (e.g., the sensor module 1076 or the communication module 1090) in volatile memory 1032, process the command or the data stored in the volatile memory 1032, and store resulting data in non-volatile memory 1034. According to an embodiment, the processor 1020 may include a main processor 1021 (e.g., a central processing unit (CPU) or an application processor (AP)), or an auxiliary processor 1023 (e.g., a graphics processing unit (GPU), a neural processing unit (NPU), an image signal processor (ISP), a sensor hub processor, or a communication processor (CP)) that is operable independently from, or in conjunction with, the main processor 1021. For example, when the electronic device 1001 includes the main processor 1021 and the auxiliary processor 1023, the auxiliary processor 1023 may be adapted to consume less power than the main processor 1021, or to be specific to a specified function. The auxiliary processor 1023 may be implemented as separate from, or as part of the main processor 1021.

The auxiliary processor 1023 may control at least some of functions or states related to at least one component (e.g., the display module 1060, the sensor module 1076, or the communication module 1090) among the components of the electronic device 1001, instead of the main processor 1021 while the main processor 1021 is in an inactive (e.g., sleep) state, or together with the main processor 1021 while the main processor 1021 is in an active state (e.g., executing an application). According to an embodiment, the auxiliary processor 1023 (e.g., an image signal processor or a communication processor) may be implemented as part of another component (e.g., the camera module 1080 or the communication module 1090) functionally related to the auxiliary processor 1023. According to an embodiment, the auxiliary processor 1023 (e.g., the neural processing unit) may include a hardware structure specified for artificial intelligence model processing. An artificial intelligence model may be generated by machine learning. Such learning may be performed, e.g., by the electronic device 1001 where the artificial intelligence is performed or via a separate server (e.g., the server 1008). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 1030 may store various data used by at least one component (e.g., the processor 1020 or the sensor module 1076) of the electronic device 1001. The various data may include, for example, software (e.g., the program 1040) and input data or output data for a command related thereto. The memory 1030 may include the volatile memory 1032 or the non-volatile memory 1034.

The program 1040 may be stored in the memory 1030 as software, and may include, for example, an operating system (OS) 1042, middleware 1044, or an application 1046.

The input module 1050 may receive a command or data to be used by another component (e.g., the processor 1020) of the electronic device 1001, from the outside (e.g., a user) of the electronic device 1001. The input module 1050 may include, for example, a microphone, a mouse, a keyboard, a key (e.g., a button), or a digital pen (e.g., a stylus pen).

The sound output module 1055 may output sound signals to the outside of the electronic device 1001. The sound output module 1055 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 1060 may visually provide information to the outside (e.g., a user) of the electronic device 1001. The display module 1060 may include, for example, a display, a hologram device, or a projector and control circuitry to control a corresponding one of the display, hologram device, and projector. According to an embodiment, the display module 1060 may include a touch sensor adapted to detect a touch, or a pressure sensor adapted to measure the intensity of force incurred by the touch.

The audio module 1070 may convert a sound into an electrical signal and vice versa. According to an embodiment, the audio module 1070 may obtain the sound via the input module 1050, or output the sound via the sound output module 1055 or a headphone of an external electronic device (e.g., an electronic device 1002) directly (e.g., wiredly) or wirelessly coupled with the electronic device 1001.

The sensor module 1076 may detect an operational state (e.g., power or temperature) of the electronic device 1001 or an environmental state (e.g., a state of a user) external to the electronic device 1001, and then generate an electrical signal or data value corresponding to the detected state. According to an embodiment, the sensor module 1076 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 1077 may support one or more specified protocols to be used for the electronic device 1001 to be coupled with the external electronic device (e.g., the electronic device 1002) directly (e.g., wiredly) or wirelessly. According to an embodiment, the interface 1077 may include, for example, a high definition multimedia interface (HDMI), a universal serial bus (USB) interface, a secure digital (SD) card interface, or an audio interface.

A connecting terminal 1078 may include a connector via which the electronic device 1001 may be physically connected with the external electronic device (e.g., the electronic device 1002). According to an embodiment, the connecting terminal 1078 may include, for example, a HDMI connector, a USB connector, a SD card connector, or an audio connector (e.g., a headphone connector).

The haptic module 1079 may convert an electrical signal into a mechanical stimulus (e.g., a vibration or a movement) or electrical stimulus which may be recognized by a user via his tactile sensation or kinesthetic sensation. According to an embodiment, the haptic module 1079 may include, for example, a motor, a piezoelectric element, or an electric stimulator.

The camera module 1080 may capture a still image or moving images. According to an embodiment, the camera module 1080 may include one or more lenses, image sensors, image signal processors, or flashes.

The power management module 1088 may manage power supplied to the electronic device 1001. According to one embodiment, the power management module 1088 may be implemented as at least part of, for example, a power management integrated circuit (PMIC).

The battery 1089 may supply power to at least one component of the electronic device 1001. According to an embodiment, the battery 1089 may include, for example, a primary cell which is not rechargeable, a secondary cell which is rechargeable, or a fuel cell.

The communication module 1090 may support establishing a direct (e.g., wired) communication channel or a wireless communication channel between the electronic device 1001 and the external electronic device (e.g., the electronic device 1002, the electronic device 1004, or the server 1008) and performing communication via the established communication channel. The communication module 1090 may include one or more communication processors that are operable independently from the processor 1020 (e.g., the application processor (AP)) and supports a direct (e.g., wired) communication or a wireless communication. According to an embodiment, the communication module 1090 may include a wireless communication module 1092 (e.g., a cellular communication module, a short-range wireless communication module, or a global navigation satellite system (GNSS) communication module) or a wired communication module 1094 (e.g., a local area network (LAN) communication module or a power line communication (PLC) module). A corresponding one of these communication modules may communicate with the external electronic device via the first network 1098 (e.g., a short-range communication network, such as Bluetooth^{™}, wireless-fidelity (Wi-Fi) direct, or infrared data association (IrDA)) or the second network 1099 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 1092 may identify and authenticate the electronic device 1001 in a communication network, such as the first network 1098 or the second network 1099, using subscriber information (e.g., international mobile subscriber identity (IMSI)) stored in the subscriber identification module 1096.

The wireless communication module 1092 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 1092 may support a high-frequency band (e.g., the mmWave band) to achieve, e.g., a high data transmission rate. The wireless communication module 1092 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 1092 may support various requirements specified in the electronic device 1001, an external electronic device (e.g., the electronic device 1004), or a network system (e.g., the second network 1099). According to an embodiment, the wireless communication module 1092 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 1097 may transmit or receive a signal or power to or from the outside (e.g., the external electronic device) of the electronic device 1001. According to an embodiment, the antenna module 1097 may include an antenna including a radiating element composed of a conductive material or a conductive pattern formed in or on a substrate (e.g., a printed circuit board (PCB)). According to an embodiment, the antenna module 1097 may include a plurality of antennas (e.g., array antennas). In such a case, at least one antenna appropriate for a communication scheme used in the communication network, such as the first network 1098 or the second network 1099, may be selected, for example, by the communication module 1090 (e.g., the wireless communication module 1092) from the plurality of antennas. The signal or the power may then be transmitted or received between the communication module 1090 and the external electronic device via the selected at least one antenna. According to an embodiment, another component (e.g., a radio frequency integrated circuit (RFIC)) other than the radiating element may be additionally formed as part of the antenna module 1097.

According to various embodiments, the antenna module 1097 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 1001 and the external electronic device 1004 via the server 1008 coupled with the second network 1099. Each of the electronic devices 1002 or 1004 may be a device of a same type as, or a different type, from the electronic device 1001. According to an embodiment, all or some of operations to be executed at the electronic device 1001 may be executed at one or more of the external electronic devices 1002, 1004, or 1008. For example, if the electronic device 1001 should perform a function or a service automatically, or in response to a request from a user or another device, the electronic device 1001, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1001. The electronic device 1001 may provide the outcome, with or without further processing of the outcome, as at least part of a reply to the request. To that end, a cloud computing, distributed computing, mobile edge computing (MEC), or client-server computing technology may be used, for example. The electronic device 1001 may provide ultra low-latency services using, e.g., distributed computing or mobile edge computing. In another embodiment, the external electronic device 1004 may include an internet-of-things (IoT) device. The server 1008 may be an intelligent server using machine learning and/or a neural network. According to an embodiment, the external electronic device 1004 or the server 1008 may be included in the second network 1099. The electronic device 1001 may be applied to intelligent services (e.g., smart home, smart city, smart car, or healthcare) based on 5G communication technology or IoT-related technology.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program) including one or more instructions that are stored in a storage medium (e.g., internal memory or external memory) that is readable by a machine (e.g., the electronic device). For example, a processor (e.g., the processor) of the machine (e.g., the electronic device) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

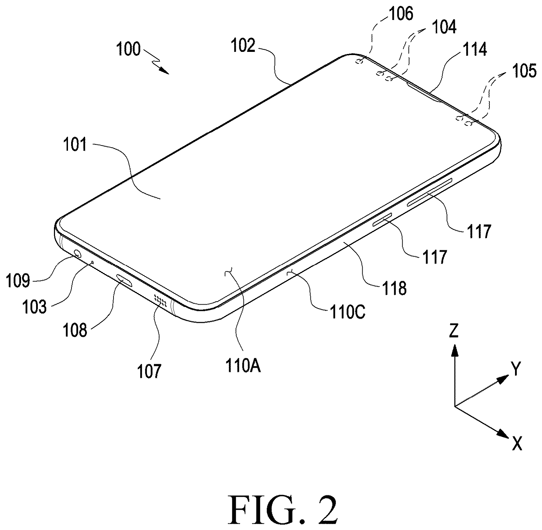

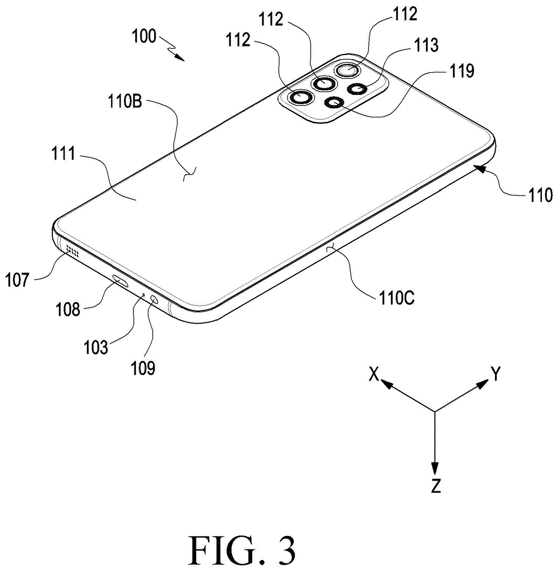

FIG. 2 is a front perspective view of an electronic device 100 according to an embodiment of the disclosure. FIG. 3 is a rear perspective view of the electronic device 100 of FIG. 2 according to an embodiment of the disclosure.

Referring to FIGS. 2 and 3, the electronic device 100 (e.g., the electronic device 1001 in FIG. 1) according to an embodiment may include a housing 110 including a first surface (or the front surface) 110A, a second surface (or the rear surface) 110B, and a side surface 110C surrounding the space between the first surface 110A and the second surface 110B. In an embodiment (not illustrated), the housing 110 may refer to a structure that forms a portion of the first surface 110A of FIG. 2, and the second surface 110B and the side surface 110C of FIG. 3. According to an embodiment, at least a portion of the first surface 110A may be made of a substantially transparent front surface plate 102 (e.g., a glass plate or a polymer plate including various coating layers). The second surface 110B may be made of a substantially opaque rear surface plate 111. The rear surface plate 111 may be made of, for example, coated or colored glass, ceramic, polymer, metal (e.g., aluminum, stainless steel (STS), or magnesium), or a combination of two or more of these materials. The side surface 110C may be defined by the side structure (or a "side bezel structure") 118 coupled to the front surface plate 102 and the rear surface plate 111 and including metal and/or polymer. In an embodiment, the rear surface plate 111 and the side structure 118 may be integrated with each other and may include the same material (e.g., a metal material such as aluminum).

Although not illustrated, the front surface plate 102 may include one or more regions that are curved and extend seamlessly from at least a portion of an edge toward the rear surface plate 111. In an embodiment, the front surface plate 102 (or the rear surface plate 111) may include only one of the regions curved and extended toward the rear surface plate 111 (or the front surface plate 102), at one side edge of the first surface 110A. According to an embodiment, the front surface plate 102 or the rear surface plate 111 may be substantially flat in shape. For example, the front surface plate or the rear surface plate may not include a region that is curved and extended. When the curved and extended region is included, the thickness of the electronic device 100 in the portion including the curved and extended region may be smaller than the thicknesses of other portions.

According to an embodiment, the electronic device 100 may include at least one of a display 101, an audio module (e.g., a microphone hole 103, an external speaker hole 107, and a call receiver hole 114), a sensor module (e.g., a first sensor module 104, a second sensor module (not illustrated), and a third sensor module 119), a camera module (e.g., a first camera device 105, a second camera device 112, and a flash 113), key input devices 117, a light-emitting element 106, and connector holes (e.g., a first connector hole 108 and a second connector hole 109). In an embodiment, at least one of the components (e.g., the key input devices 117 or the light-emitting element 106) may be omitted from the electronic device 100 or other components may be additionally included.

The display 101 may output a screen or may be visually exposed through, for example, a substantial portion of the first surface 110A (e.g., the front surface plate 102). In an embodiment, at least a portion of the display 101 may be visually exposed through the front surface plate 102 forming the first surface 110A or through a portion of the side surface 110C. In an embodiment, the edge of the display 101 may be formed to be substantially the same as the shape of the periphery of the front surface plate 102 adjacent thereto. In an embodiment (not illustrated), the distance between the periphery of the display 101 and the periphery of the front surface plate 102 may be substantially constant in order to enlarge the visually exposed area of the display 101.

In an embodiment (not illustrated), recesses or openings may be provided in some portions of the screen display region of the display 101, and one or more of an audio module (e.g., the call receiver hole 114), a sensor module (e.g., the first sensor module 104), a camera module (e.g., the first camera module 105), and a light-emitting element 106 may be aligned with the recesses or the openings. In an embodiment (not illustrated), the rear surface of the screen display region of the display 101 may include at least one of an audio module (e.g., the call receiver hole 114), a sensor module (e.g., the first sensor module 104), a camera module (e.g., the first camera device 105), a fingerprint sensor (not illustrated), and a light-emitting element 106. In an embodiment (not illustrated), the display 101 may be coupled to or disposed adjacent to a touch-sensitive circuit, a pressure sensor capable of measuring a touch intensity (pressure), and/or a digitizer configured to detect an electromagnetic field-type stylus pen. In an embodiment, when the front surface plate 102 or the rear surface plate 111 includes one or more curved and extended regions, at least a portion of the sensor modules (e.g., the first sensor module 104 and the third sensor module 119), and/or at least a portion of the key input devices 117 may be arranged in the one or more curved and extended regions.

The audio module 103, 107, and 114 may include a microphone hole 103 and speaker holes (e.g., the external speaker hole 107 and the call receiver hole 114). A microphone configured to acquire external sound may be placed inside the microphone hole 103, and in an embodiment, multiple microphones may be placed to detect the direction of sound. The speaker holes may include an external speaker hole 107 and a call receiver hole 114. In an embodiment, the speaker holes (e.g., the external speaker hole 107 and the call receiver hole 114) and the microphone hole 103 may be implemented as a single hole, or a speaker may be included without the speaker holes (e.g., the external speaker hole 107 and the call receiver hole 114) (e.g., a piezo speaker).

The sensor modules may generate electrical signals or data values corresponding to the internal operating states or the external environmental states of the electronic device 100. The sensor modules may include, for example, a first sensor module 104 (e.g., a proximity sensor) and/or a second sensor module (not illustrated) (e.g., a fingerprint sensor) disposed on the first surface 110A of the housing 110, and/or a third sensor module 119 disposed on the second surface 110B of the housing 110. The second sensor module (not illustrated) (e.g., a fingerprint sensor) may be disposed not only on the first surface 110A (e.g., the display 101) of the housing 110, but also on the second surface 110B or the side surface 110C of the housing 110. The electronic device 100 may further include at least one of, for example, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

The camera modules may include a first camera device 105 disposed on the first surface 110A of the electronic device 100, and a second camera device 112 and/or a flash 113 disposed on the second surface 110B of the electronic device 100. The camera devices (e.g., the first camera device 105 and the second camera device 112) may include one or more lenses, an image sensor, and/or an image signal processor. The flash 113 may include, for example, a light-emitting diode or a xenon lamp. In an embodiment, one or more lenses (e.g., an infrared camera lens, a wide-angle lens, and a telephoto lens) and image sensors may be disposed on one surface of the electronic device 100. In an embodiment, the flash 113 may emit infrared rays, and the infrared light emitted by the flash 113 and reflected by a subject may be received through the third sensor module 119. The electronic device 100 or the processor (e.g., the processor 1020 in FIG. 1) of the electronic device 100 may detect depth information of the subject based on a time point when the infrared rays are received by the third sensor module 119.

The key input devices 117 may be disposed on the side surface 110C of the housing 110. In an embodiment, the electronic device 100 may not include some or all of the above-described key input devices 117, and the key input devices 117 not included may be implemented in another form, such as soft keys, on the display 101. In an embodiment, the key input devices may include a sensor module disposed on the second surface 110B of the housing 110.

The light-emitting element 106 may be disposed on, for example, the first surface 110A of the housing 110. The light-emitting elements 106 may provide, for example, the state information of the electronic device 100 in an optical form. In an embodiment, the light-emitting element 106 may provide a light source that operates in conjunction with, for example, the operation of the camera module (e.g., the first camera device 105). The light-emitting element 106 may include, for example, a light-emitting diode (LED), an infrared LED, and a xenon lamp.

The connector holes (e.g., a first connector hole 108 and a second connector hole 109) may include a first connector hole 108, which is capable of accommodating a connector (e.g., a USB connector) configured to transmit/receive power and/or data to/from an external electronic device (e.g., the electronic device 1002 in FIG. 1), and/or a second connector hole (e.g., an earphone jack) 109, which is capable of accommodating a connector for transmitting/receiving an audio signal to/from an external electronic device.

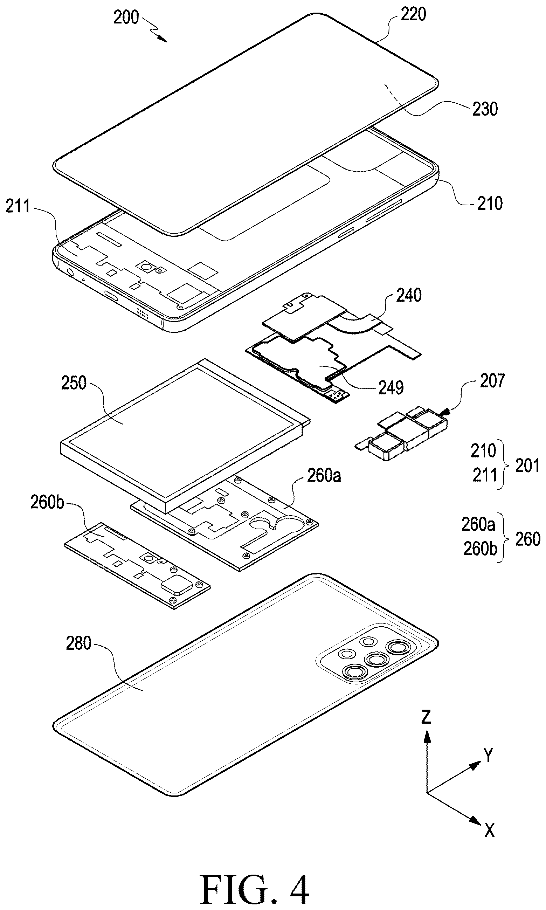

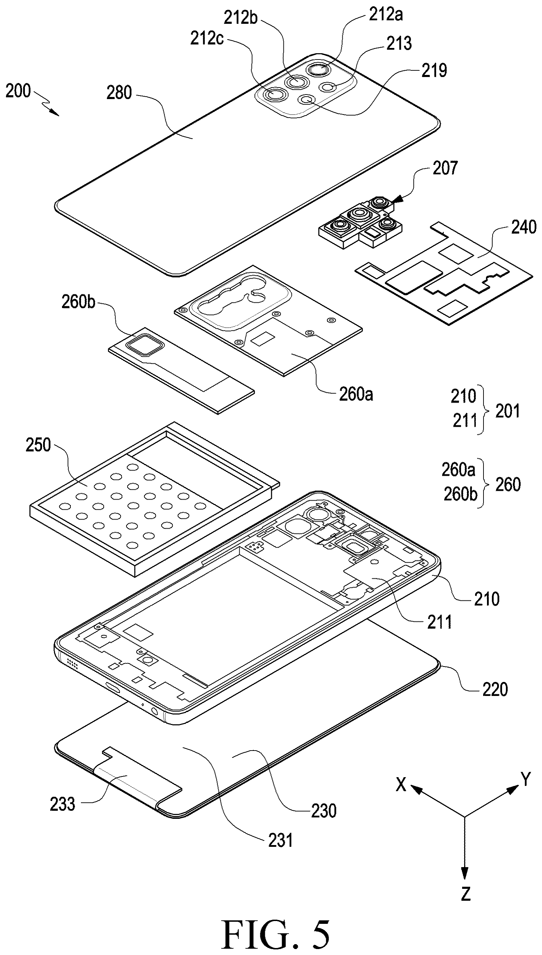

FIG. 4 is an exploded perspective view illustrating a front side of the electronic device 200 of FIG. 2, according to an embodiment of the disclosure. FIG. 5 is an exploded perspective view illustrating a rear side of the electronic device 200 of FIG. 2, according to an embodiment of the disclosure.

Referring to FIGS. 4 and 5, the electronic device 200 (e.g., the electronic device 1001, 1002, 1004, or 100 in FIG. 1, FIG. 2, or FIG. 3) may include a side structure 210, a first support member 211 (e.g., a bracket), a front surface plate 220 (e.g., the front surface plate 102 in FIG. 1), a display 230 (e.g., the display 101 in FIG. 1), a printed circuit board (or a substrate assembly) 240, a battery 250, a second support member 260 (e.g., a rear case), an antenna, a camera assembly 207, and a rear surface plate 280 (e.g., the rear surface plate 111 in FIG. 3). In an embodiment, at least one of the components (e.g., the first support member 211 or the second support member 260) may be omitted from the electronic device 200, or may additionally include other components. At least one of the components of the electronic device 200 may be the same as or similar to at least one of the components of the electronic device 100 illustrated in FIG. 2 or FIG. 3, and redundant descriptions are omitted below.

The first support member 211 may be arranged inside the electronic device 200 to be connected to the side structure 210 or may be integrated with the side structure 210. The first support member 211 may be made of, for example, a metal material and/or a non-metal (e.g., polymer) material. When at least partially being made of a metal material, a portion of the side structure 210 or the first support member 211 may serve as an antenna. The first support member 211 may include one surface to which the display 230 is coupled and the other surface to which the printed circuit board 240 is coupled. A processor (e.g., the processor 1020 in FIG. 1), memory (e.g., the memory 1030 in FIG. 1), and/or an interface (e.g., the interface 1077 in FIG. 1) may be mounted on the printed circuit board 240. The processor may include one or more of, for example, a central processing unit, an application processor, a graphics processing unit, an image signal processor, a sensor hub processor, or a communication processor. In an embodiment, the processor and/or the memory may refer to one of the circuit devices mounted on an integrated circuit chip.

According to an embodiment, the first support member 211 and the side structure 210 may be combined to be referred to as a front case or a housing 201. According to an embodiment, the housing 201 may be generally understood as a structure for accommodating, protecting, or disposing the printed circuit board 240 or the battery 250. In an embodiment, it may be understood that the housing 201 includes structures capable of being visually or tactually recognized by a user in the exterior of the electronic device 200, such as the side structure 210, the front surface plate 220, and/or the rear surface plate 280. In an embodiment, the "front surface or rear surface of the housing 201" may refer to the first surface 110A in FIG. 2 or the second surface 110B in FIG. 3. In an embodiment, the first support member 211 may be disposed between the front surface plate 220 (e.g., the first surface 110A in FIG. 2) and the rear surface plate 280 (e.g., the second surface 110B in FIG. 3) and may serve as a structure on which electrical/electronic components, such as a printed circuit board 240 or a camera assembly 207, are arranged.

The display 230 may include a display panel 231 and a flexible printed circuit board 233 extending from the display panel 231. The flexible printed circuit board 233 may be understood, for example, to be electrically connected to the display panel 231 while being disposed at least partially on the rear surface of the display panel 231. In an embodiment, reference numeral "231" may be understood as denoting a protective sheet disposed on the rear surface of the display panel. For example, unless otherwise classified in the following detailed description, the protective sheet may be understood as being a portion of the display panel 231. In an embodiment, the protective sheet may function as a buffer structure (e.g., a low-density elastic material such as a sponge) absorbing an external force or an electromagnetic shield structure (e.g., a copper sheet (CU sheet)). According to an embodiment, the display 230 may be disposed on the inner surface of the front surface plate 220 and may include a light-emitting layer to output a screen through at least a portion of the first surface 110A of FIG. 2 or the front surface plate 220. As mentioned above, the display 230 may output a screen through substantially the entire area of the first surface 110A of FIG. 2 or the front surface plate 220.

The memory may include, for example, volatile memory or non-volatile memory.

The interface may include, for example, a high-definition multimedia interface (HDMI), a universal serial bus (USB) interface, an SD card interface, and/or an audio interface. For example, the interface may electrically or physically connect the electronic device 200 to an external electronic device, and include a USB connector, an SD card/MMC connector, or an audio connector.

The second support member 260 may include, for example, an upper support member 260a and a lower support member 260b. In an embodiment, the upper support member 260a may be disposed to surround the printed circuit board 240 together with a portion of the first support member 211. A circuit device implemented in the form of an integrated circuit chip (e.g., a processor, a communication module, or memory) or various electrical/electronic components may be disposed on the printed circuit board 240, and in some embodiments, the printed circuit board 240 may be provided with an electromagnetic shielding environment from the upper support member 260a. In an embodiment, at least one shield can 249 may be disposed on the printed circuit board 240. For example, the shield can 249 may provide an electromagnetic shielding environment to a portion or space on the printed circuit board 240. In an embodiment, the shield can 249 may be arranged to surround at least a portion of a processor, memory, and/or an integrated circuit chip having a communication module mounted thereon.

According to an embodiment, the lower support member 260b may utilized as a structure for disposing electric/electronic components such as a speaker module and an interface (e.g., a USB connector, an SD card/MMC connector, or an audio connector). In an embodiment, electrical/electronic components, such as a speaker module and an interface (e.g., a USB connector, an SD card/MMC connector, or an audio connector), may be disposed on an additional printed circuit board (not illustrated). For example, the lower support member 260b may be disposed to surround the additional printed circuit board together with another portion of the first support member 211. The speaker module or interface disposed on the additional printed circuit board (not illustrated) or the lower support member 260b may be arranged to correspond to the audio module of FIG. 2 (e.g., the microphone hole 103 or the speaker holes (e.g., the external speaker hole 107 and the call receiver hole 114)) or the connector holes (e.g., the first connector hole 108 and the second connector hole 109).

The battery 250 may serve as a device that supplies power to at least one component of the electronic device 200, and may include, for example, a non-rechargeable primary cell, a rechargeable secondary cell, or a fuel cell. At least a portion of the battery 250 may be disposed on substantially the same plane as, for example, the printed circuit board 240. The battery 250 may be integrally disposed inside the electronic device 200, or may be disposed to be detachable from the electronic device 200.

Although not illustrated, the antenna may include a conductive pattern implemented on the surface of the first support member 211 and/or the surface of the second support member 260, for example, through laser direct structuring (LDS) techniques. In an embodiment, the antenna may include a printed circuit pattern provided on the surface of a thin film, and the thin film-type antenna may be disposed between the rear surface plate 280 and the battery 250. The antenna may include, for example, a near-field communication (NFC) antenna, a wireless charging antenna, and/or a magnetic secure transmission (MST) antenna. The antenna may, for example, perform near-field communication with an external device, or wirelessly transmit and receive power required for charging. In an embodiment, an antenna structure may be configured with a portion or a combination of the side structure 210 and/or the first support member 211.

The camera assembly 207 may include at least one camera module. Inside the electronic device 200, the camera assembly 207 may receive at least a portion of light incident through optical holes or camera windows 212a, 212b, 212c, 213, and 219. In an embodiment, the camera assembly 207 may be disposed on the first support member 211 at a position adjacent to the printed circuit board 240. In an embodiment, the camera modules of the camera assembly 207 may be generally aligned with one of the camera windows 212a, 212b, 212c, 213, and 219, and may be at least partially surrounded by the second support member 260 (e.g., the upper support member 260a).

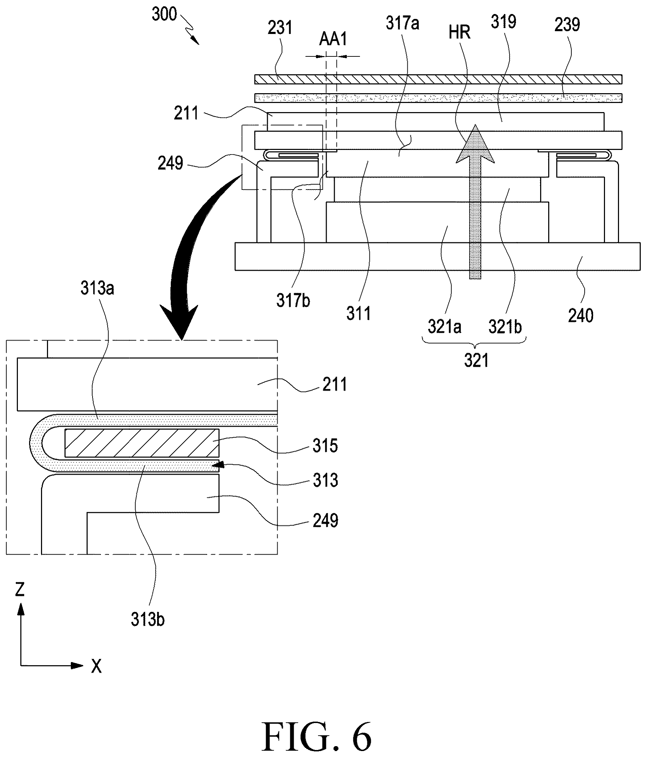

In discussing the embodiments described below, the above-described configurations of the electronic devices 1001, 1002, 1004, 100, and 200 may be referred to. Even if not directly mentioned, the configurations of the embodiments described above may be similarly applied to the embodiments described below. It should be noted that the orthogonal coordinate system referred to in an embodiment described above and/or described below is exemplified for the sake of brevity of explanation, and one or more embodiments of the disclosure is(are) not limited thereto. For example, the orthogonal coordinate system mentioned in the disclosure may be defined differently depending on the shape of an electronic device to be actually manufactured (e.g., bar type, foldable type, rollable type, and/or slide type), a user's usage habits, and/or the orientation direction of the electronic device. In the exemplified embodiments, the X-axis direction may refer to the width direction of the electronic device, the Y-axis direction may refer to the length direction of the electronic device. And/or the Z-axis direction may refer to a thickness direction of the electronic device. In the embodiments described below, when an integrated circuit chip generates heat, the direction in which the heat is transferred through a contact type thermal interface material (TIM) (e.g., the direction illustrated by the arrow "HR" in FIG. 6) may be substantially parallel to the Z-axis direction.

FIG. 6 is a view illustrating a heat dissipation structure 300 of an electronic device (e.g., the electronic devices 1001, 1002, 1004, 100, and 200 of FIGS. 1 to 5) according to an embodiment of the disclosure.

Referring to FIG. 6, the electronic device 200 may include a first support member 211, a printed circuit board 240, an integrated circuit chip 321, a thermal interface material (TIM) 311, and/or a shielding film 313. The thermal interface material 311 may function as at least a portion of the heat dissipation structure 300 that transfers or disperses heat generated in a predetermined region or in an electric element (e.g., the integrated circuit chip 321) inside the electronic device 200 to another region or structure. In an embodiment, the shielding film 313 may be disposed to surround at least a portion of the integrated circuit chip 321 to provide an electromagnetic shielding function. For example, the shielding film 313 may provide an electromagnetic shielding structure by being electrically connected to a ground provided on the printed circuit board 240 and/or the first support member 211. In an embodiment, the shielding film 313 may function as at least a portion of the shield can 249 of FIG. 4, depending on the manufacturing specifications or the shape in which the shielding film is disposed on the printed circuit board 240.

According to an embodiment, the thermal interface material 311 provided as a portion of the heat dissipation structure 300 may transfer heat or promote heat transfer from a high-temperature space (or component) to a low-temperature space (or component). For example, when heat is generated from an integrated circuit chip 321 including a circuit device such as a processor 321a (e.g., the processor 1020 of FIG. 1), the thermal interface material 311 may absorb, transfer, or disperse the generated heat. The thermal interface material 311 may transfer the heat absorbed from the integrated circuit chip 321 to another structure (e.g., the first support member 211) inside the electronic device 200. For example, the thermal interface material 311 may transfer heat between the integrated circuit chip 321 and the first support member 211. Since heat is generally generated from the integrated circuit chip 321 when the electronic device 200 operates, the expression "transferring heat between the integrated circuit chip 321 and the first support member 211" may refer to transferring or dispersing heat generated from the integrated circuit chip 321 to the first support member 211.

According to an embodiment, the first support member 211 may at least partially include a thermally conductive material and/or an electrically conductive material. In an embodiment, when heat is transferred through the thermal interface material 311, the first support member 211 may disperse the heat to another region or over a wider area. In an embodiment, when the first support member 211 is directly connected to or integrally formed with a side structure (e.g., the side structure 210 of FIG. 4 or FIG. 5), the heat may reach the side structure 210 via the first support member 211. In an embodiment, heat generated from the integrated circuit chip 321 and/or heat transferred through the first support member 211 may be released to an external space of the electronic device 200 through the side structure 210. As such, when heat is generated in a small component and/or a narrow area such as the integrated circuit chip 321 on which the processor 321a is mounted, the electronic device 200 may suppress an increase in temperature around the integrated circuit chip 321 by providing a structure that disperses the generated heat over a wider area.

According to an embodiment, the printed circuit board 240 may be disposed to face the first support member 211 between a rear surface of the electronic device 200 (e.g., the rear surface plate 280 of FIG. 4 or FIG. 5) and the first support member 211. In an embodiment, a display panel 231 (e.g., the display 230 of FIG. 4 or FIG. 5) may be disposed to face the printed circuit board 240 with the first support member 211 interposed therebetween. Various electric elements, such as the integrated circuit chip 321, may be disposed on the printed circuit board 240. In an embodiment, an integrated circuit chip 321 that may generate heat, such as a processor 321a and/or a communication module (e.g., the communication module 1090 of FIG. 1), may be disposed adjacent to a thermally conductive structure. For example, the integrated circuit chip 321 may be provided in an environment that allows heat to be rapidly dispersed to another space or structure. In the illustrated embodiment, the integrated circuit chip 321 on which the processor 321a is mounted may be disposed on one surface of the printed circuit board 240, and thus may be substantially positioned between the printed circuit board 240 and the first support member 211. For example, heat generated from the integrated circuit chip 321 may be dispersed or dissipated through the first support member 211.

According to an embodiment, the integrated circuit chip 321 may further include memory 321b (e.g., the memory 1030 of FIG. 1) disposed on one surface of the processor 321a. For example, the memory 321b may be disposed between the processor 321a and a contact type thermal interface material 311 described below. When the integrated circuit chip 321 further includes the memory 321b, the contact type thermal interface material 311 may be disposed to be substantially in contact with the memory 321b. For example, the thermal interface material 311 may absorb heat from the processor 321a or the memory 321b and may transfer the heat to the first support member 211. According to an embodiment, the memory 321b may be omitted, in which case the thermal interface material 311 may be disposed to be in direct contact with the processor 321a in contact with the integrated circuit chip 321.

According to an embodiment, the thermal interface material 311 may be disposed between the integrated circuit chip 321 and the first support member 211 to promote transfer or dispersion of heat generated from the integrated circuit chip 321. For example, the thermal interface material 311 may transfer heat from the integrated circuit chip 321 to the first support member 211 by having at least a portion of one surface in contact with the integrated circuit chip 321 and at least a portion of the other surface in contact with the first support member 211. In an embodiment, the thermal interface material 311 may be made of a synthetic resin containing a thermally conductive material and may be formed in a compressible three-dimensional shape (e.g., a plate shape having a predetermined thickness (hereinafter referred to as a "solid state")). Here, the term "thermally conductive material" may refer to, for example, aluminum oxide (Al₂O₃), aluminum nitride (AlN), and/or carbon fiber. The term "compressible" may refer to a property of contracting under an external force while accumulating elastic force, and when no external force is applied, the solid-state thermal interface material 311 may return to its originally manufactured shape. For example, when disposed between the integrated circuit chip 321 and the first support member 211, the thermal interface material 311 may be compressed into a predetermined shape. In the compressed state, the thermal interface material 311 may be in close contact with the integrated circuit chip 321 and/or the first support member 211, which may facilitate absorption of heat from the integrated circuit chip 321 or transfer of heat to the first support member 211.

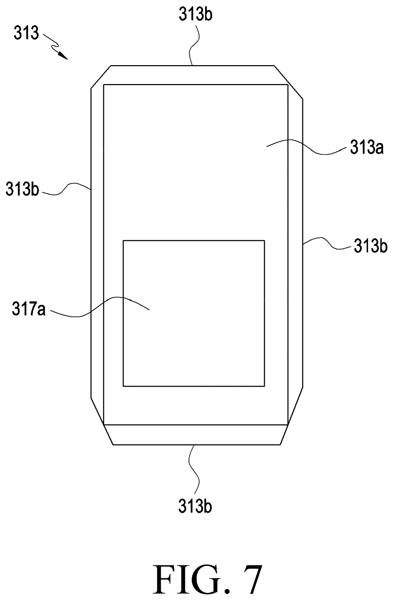

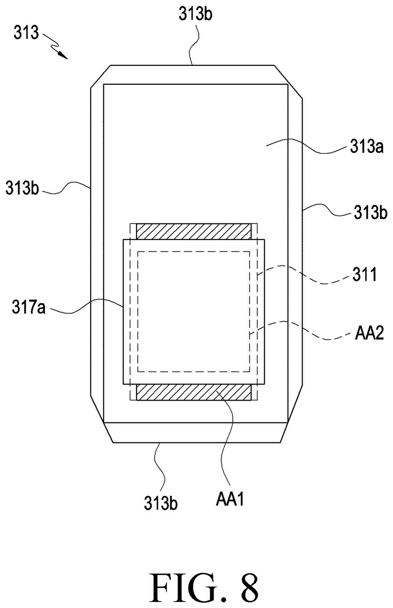

According to an embodiment, the shielding film 313 may be partially disposed between the thermal interface material 311 and the first support member 211. For example, the shielding film 313 may be attached to at least a portion of an edge of the thermal interface material 311 and may provide a first opening 317a to allow the thermal interface material 311 to be in direct contact with the first support member 211 through the first opening 317a. Embodiments of the shielding film 313 will be further described with reference to FIGS. 7 and 8.

FIG. 7 is a view illustrating the shielding film 313 in a heat dissipation structure 300 of an electronic device 200 according to an embodiment of the disclosure. FIG. 8 is a view illustrating a state in which a thermal interface material 311 is disposed on the shielding film 313 in the heat dissipation structure 300 of the electronic device 200 according to an embodiment of the disclosure.

Referring further to FIGS. 7 and 8, at least a portion of an edge of the other surface of the thermal interface material 311 may be attached to the shielding film 313 around the first opening 317a. When viewed in the Z-axis direction or in the direction of heat flow illustrated by the arrow "HR" in FIG. 6, a portion indicated by "AA1" in FIG. 8 may illustrate a region where the other surface of the thermal interface material 311 is attached to the shielding film 313. Except for the region indicated by "AA1," the other surface of the thermal interface material 311 may be substantially in contact with the first support member 211. In an embodiment, the portion indicated by "AA1" in FIG. 8 may be understood as a portion of the shielding film 313 disposed between the thermal interface material 311 and the first support member 211. When viewed in the Z-axis direction or in the direction of heat flow illustrated by the arrow "HR" in FIG. 6, a portion indicated by "AA2" in FIG. 8 may illustrate a portion where one surface of the thermal interface material 311 is in contact with the integrated circuit chip 321 (e.g., the memory of FIG. 6). For example, a second portion of the thermal interface material 311 (e.g., the portion indicated by "AA1") may laterally protrude from a first portion that is in contact with the integrated circuit chip 321 (e.g., the portion indicated by "AA2"), and at least a portion of the second portion may be attached to the shielding film 313.

According to an embodiment, when viewed along the Z-axis direction, the portion of the thermal interface material 311 attached to the shielding film 313 (e.g., the portion indicated by "AA1" in FIG. 8) may be at least partially disposed around a portion where the thermal interface material 311 is in contact with the integrated circuit chip 321. When viewed along the Z-axis direction, depending on manufacturing tolerances or assembly tolerances in arrangement with respect to the integrated circuit chip 321, a portion of the thermal interface material 311 attached to the shielding film 313 (e.g., the region indicated by "AA1") may be disposed to be in partial contact with a portion of the thermal interface material 311 that is in contact with the integrated circuit chip 321 (e.g., the region indicated by "AA2"). For example, the first opening 317a may be formed smaller and/or arranged in a different position than illustrated in FIG. 8, in which case a portion of the region indicated by "AA1" in FIG. 8 may overlap the region indicated by "AA2." In an embodiment, in a state of being attached to the thermal interface material 311, the shielding film 313 may be disposed on (above) the printed circuit board 240 or on the first support member 211, so as to allow the thermal interface material 311 to be disposed on the integrated circuit chip 321. For example, the shielding film 313 may be disposed on the printed circuit board 240 in a state of at least partially surrounding the integrated circuit chip 321, so as to allow the thermal interface material 311 to be disposed to be in contact with the integrated circuit chip 321.

In an embodiment, the shielding film 313 may be substantially implemented by an array of multiple nanofibers and may include an electrically conductive material (e.g., nickel (Ni) or copper (Cu)) infiltrated into spaces between the nanofibers. For example, the shielding film 313 may have electrical conductivity. In an embodiment, the shielding film 313 may be electrically connected to the printed circuit board 240 (e.g., a ground) and/or the first support member 211. For example, when the first support member 211 includes an electrically conductive material, the shielding film 313 may implement an electromagnetic shielding structure together with at least a portion of the first support member 211. In an embodiment, the shielding film 313 may be disposed to at least partially surround the integrated circuit chip 321 or a space in which the integrated circuit chip 321 is disposed, so as to allow the shielding film 313 and/or the first support member 211 to electromagnetically isolate the integrated circuit chip 321 from a surrounding space.

According to an embodiment, the electronic device 200 may further include a shield can 249. The shield can 249 may be a shielding component fabricated by processing an electrically conductive metal plate into a cup, cover, or enclosure shape that surrounds the integrated circuit chip 321, and may be disposed on the printed circuit board 240 to implement an electromagnetic shielding structure. In an embodiment, the shielding film 313 may be electrically connected to the printed circuit board 240 (e.g., a ground) by being substantially attached to the shield can 249. In an embodiment, the shielding film 313 itself may be implemented to substantially surround the integrated circuit chip 321, and the shield can 249 may be omitted. In an embodiment, since the shielding film 313 may be formed to have a relatively thin thickness (e.g., about 20 to 40 micrometers) to provide flexibility, the shield can 249 having a defined shape may additionally be provided in consideration of assembly, structural stability, and/or ease of handling during an assembly process.

According to an embodiment, when the electronic device 200 further includes a shield can 249, the shield can 249 may provide a second opening 317b corresponding to the integrated circuit chip 321 or the first opening 317a. For example, the thermal interface material 311 may be at least partially in contact with the integrated circuit chip 321 inside the shield can 249 through the second opening 317b. In an embodiment, the second opening 317b may have a larger size than the first opening 317a. For example, when viewed along the Z-axis direction, a portion of the thermal interface material 311 attached to the shielding film 313 may be positioned outside the first opening 317a while being disposed inside the second opening 317b. Accordingly, one surface of the thermal interface material 311 may be in direct contact with one of the shielding film 313 and the first support member 211, while a peripheral portion of a region where the other surface of the thermal interface material 311 (e.g., the region indicated by "AA2") is in contact with the integrated circuit chip 321 may be disposed inside the shield can 249 without being in contact with another structure.

According to an embodiment, when the shield can 249 does not include the second opening 317b, a more stable electromagnetic shielding structure may be provided. When the second opening 317b is not included, the shield can 249 may be partially disposed on a heat flow path, for example, on the path indicated by the arrow "HR" in FIG. 6. When the shield can 249 is disposed on the heat flow path, heat transfer efficiency to the first support member 211 may be reduced, or heat generated from the integrated circuit chip 321 may flow back to the printed circuit board 240 through the shield can 249. For example, by forming the second opening 317b and disposing the thermal interface material 311 through the second opening, favorable heat dissipation performance may be ensured.

According to an embodiment, by disposing the shielding film 313 and/or by electrically connecting the shield can 249 and the first support member 211 through the shielding film 313, degradation in electromagnetic shielding performance caused by the second opening 317b may be suppressed. For example, the shielding film 313 and/or the first support member 211 may provide an electromagnetic shielding structure in a portion corresponding to the second opening 317b, while the first support member 211 may function as a portion of the heat dissipation structure 300. In an embodiment, when the shielding film 313 is in contact with (or attached to) the shield can 249 and/or the first support member 211, the contact may be made along a closed-curve trace or a polygonal trace surrounding the first opening 317a and/or the second opening 317b. For example, the first opening 317a and/or the second opening 317b may be a region that deteriorates electromagnetic shielding performance, and by electrically connecting the first support member 211 to the shielding film 313 and/or the shield can 249, degradation in electromagnetic shielding performance caused by the first opening 317a and/or the second opening 317b may be suppressed. In an embodiment, when the shielding film 313 is in contact with (or attached to) the shield can 249 and/or the first support member 211 along the closed-curve trace or a polygonal trace surrounding the first opening 317a and/or the second opening 317b, an electromagnetic leakage path may be suppressed from being generated between the shielding film 313 and the shield can 249 and/or between the shielding film 313 and the first support member 211.

According to an embodiment, when the electronic device 200 includes the shield can 249, a more stable electrical connection structure may be implemented between the shielding film 313 and the shield can 249 and/or between the shielding film 313 and the first support member 211 by further including an elastic member 315. For example, when the printed circuit board 240 is assembled on the first support member 211, the elastic member 315 may provide an elastic force to bring the shielding film 313 into close contact with the shield can 249 and/or the first support member 211. The elastic member 315 may be provided, for example, on at least a portion of a periphery of the first opening 317a and/or the second opening 317b. In an embodiment, the elastic member 315 may be provided in a substantially closed-curve shape so as to be provided around the entire periphery of the first opening 317a and/or the entire periphery of the second opening 317b. In an embodiment, the elastic member 315 may be disposed along a trace (e.g., a closed-curve trace or a polygonal trace) where the shielding film 313 is in contact with (or attached to) the shield can 249 and/or the first support member 211. For example, the elastic member 315 may have a substantially closed-curve or polygonal frame shape and may provide an elastic force that brings the shielding film 313 into close contact with the shield can 249 and/or the first support member 211. In an embodiment, when the shielding film 313 itself has a structure capable of being brought into close contact with the shield can 249 and/or the first support member 211, the elastic member 315 may be omitted or may provide an elastic force that brings the shielding film 313 into close contact with the printed circuit board 240.

According to an embodiment, the shielding film 313 may include a first contact region 313a that provides the first opening 317a, and one or more second contact regions 313b provided around the first contact region 313a. The first contact region 313a may be a region that is substantially in contact with the first support member 211, and the second contact region 313b may be a region that is at least partially in contact with the shield can 249. In an embodiment, the second contact region 313b may be bent from the state illustrated in FIG. 7 or FIG. 8 so as to be arranged to partially face the first contact region 313a. When the second contact region 313b is in a bent state, the elastic member 315 may be disposed at least partially between the first contact region 313a and the second contact region 313b. For example, the shielding film 313 may be disposed to surround at least a portion of the elastic member 315.

According to an embodiment, the shielding film 313 may be disposed to surround both surfaces of the elastic member 315. Thus, at least a portion of the first contact region 313a may be disposed between the elastic member 315 and the first support member 211 to be in close contact with the first support member 211, and at least a portion of the second contact region 313b may be disposed between the elastic member 315 and the shield can 249 to be in close contact with the shield can 249. According to an embodiment, the expression "the first contact region 313a or the second contact region 313b is in close contact" may refer to the shielding film 313 being electrically connected to the first support member 211 and/or the shield can 249 in a more stable state. In an embodiment, a portion of the shielding film 313 (e.g., at least a portion of the first contact region 313a) may be in contact with the first support member 211 along a closed-curve trace corresponding to the elastic member 315, and another portion of the shielding film 313 (e.g., at least a portion of the second contact region 313b) may be in contact with the shield can 249 along a closed-curve trace corresponding to the elastic member 315.

As described above, the electronic device 200 according to embodiments of the disclosure may rapidly transfer, diffuse, or release heat generated from an electric element, such as the integrated circuit chip 321, to another structure (e.g., the first support member 211) or to the outside by including a heat dissipation structure 300 having a thermal interface material 311. For example, the electronic device 200 may stably perform its functions even when operating in an environment in which a large amount of data (e.g., video) is processed or when operated for a long period of time.

According to an embodiment, the electronic device 200 may further include a heat pipe, a vapor chamber 319, and/or a graphite sheet 239. The heat pipe or vapor chamber 319 may rapidly absorb and transfer or diffuse heat generated in a localized region, and the graphite sheet 239 may suppress local temperature deviations across the entire region of the electronic device 200. For example, the heat pipe or vapor chamber 319 and/or graphite sheet 239 may suppress heat from concentrating into a specific portion of the electronic device 200. By including the heat pipe or vapor chamber 319, and/or graphite sheet 239, the electronic device 200 may suppress or prevent injuries such as low-temperature burns.

According to an embodiment, the heat pipe or vapor chamber 319 may be a pipe or chamber in which a cooling medium is sealed, and the cooling medium may undergo a phase change while absorbing or releasing heat. For example, the cooling medium may absorb heat by evaporating in a region adjacent to an electric element (e.g., the integrated circuit chip 321) that generates heat, and may release heat by condensing after circulating inside the heat pipe or vapor chamber 319 and reaching a lower-temperature region. Thus, the heat pipe or vapor chamber 319 may absorb generated heat and rapidly transfer or diffuse it to another region. As the size of the heat pipe or vapor chamber 319 or the amount of cooling medium encapsulated therein increases, the rate of heat transfer, diffusion, and/or dissipation may increase. For example, as the length, width, and/or thickness of the heat pipe or vapor chamber 319 increases, the heat dissipation performance may be improved.

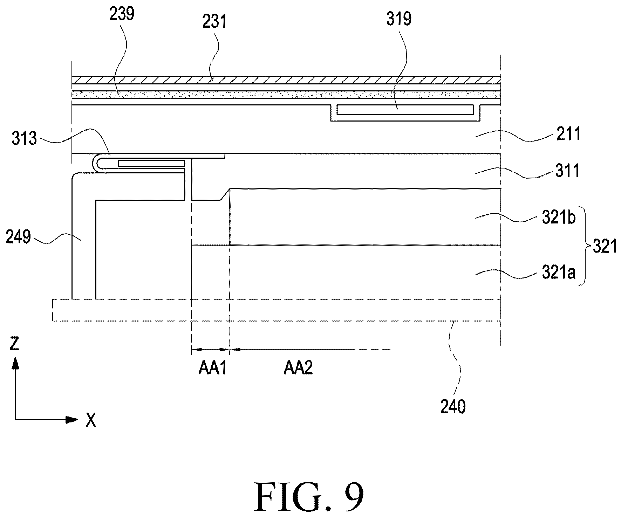

According to an embodiment, when arranging the heat pipe or vapor chamber 319 inside the electronic device 200, a hole or a recess may be provided in the first support member 211. For example, in a miniaturized electronic device 200, the heat pipe or vapor chamber 319 may be accommodated in or embedded into a structure such as the first support member 211. An embodiment in which the heat pipe or vapor chamber 319 is accommodated in or embedded into the first support member 211 may be illustrated in the embodiment described later with reference to FIG. 9. However, when a hole or a recess is provided in the first support member 211, the electronic device 200 may be easily deformed or damaged due to an external load. Therefore, when the heat pipe or vapor chamber 319 is disposed, the number and size of holes (or recesses) formed in the first support member 211 may be limited. For example, in designing the size and arrangement of the heat pipe or vapor chamber 319, both the heat dissipation performance and the strength of the electronic device 200 may be taken into consideration.

According to an embodiment, the graphite sheet 239 may complement both the heat dissipation performance and the structural rigidity of the electronic device 200. For example, when the size of the heat pipe or vapor chamber 319 is limited to ensure rigidity, the graphite sheet 239 having good thermal conductivity may be disposed to disperse the heat absorbed by the heat pipe or vapor chamber 319 over a wider area. In an embodiment, the graphite sheet 239 may be disposed between the first support member 211 and the display panel 231 (e.g., the display 230 illustrated in FIG. 4 or FIG. 5). In an embodiment, when viewed along the Z-axis direction, the graphite sheet 239 may be provided to substantially correspond to the entire area of the first support member 211 and/or the entire area of the display panel 231. In an embodiment, since the heat pipe or vapor chamber 319 is substantially accommodated in or embedded into the first support member 211 as mentioned above, a portion of the graphite sheet 239 may be disposed between the heat pipe and the display panel 231 (or between the vapor chamber 319 and the display 230). For example, the graphite sheet 239 may absorb heat generated from at least a portion of the display (e.g., the display panel 231) and/or from a portion disposed to correspond to the vapor chamber 319, and may disperse the absorbed heat to other regions. Thus, even when the heat pipe or vapor chamber 319 is miniaturized, the graphite sheet 239 may complement the heat dissipation performance, and miniaturization of the heat pipe or vapor chamber 319 may suppress degradation in the rigidity of the first support member 211 and/or the electronic device 200.

FIG. 9 is a view illustrating a heat dissipation structure 300 of an electronic device 200 according to an embodiment of the disclosure.

Referring also to FIG. 9, in a state in which a contact type thermal interface material 311 is disposed between an integrated circuit chip 321 and a first support member 211, a portion of the thermal interface material 311 (e.g., a region of the thermal interface material 311 that is not in contact with the integrated circuit chip 321) may be disposed closer to a printed circuit board 240 than other portions. As described above, the thermal interface material 311 is a compressible solid component, and a portion that is in direct contact with the integrated circuit chip 321 and/or the first support member 211 may be compressed to a predetermined size. In an embodiment, an AA1 region may be a portion substantially attached to the shielding film 313, pressed by the first support member 211 and/or the shielding film 313, and disposed on a second opening 317b but not in contact with the integrated circuit chip 321. In an embodiment, an AA2 region may be a portion that is in contact with the integrated circuit chip 321 and substantially disposed between the first support member 211 and the integrated circuit chip 321. For example, the AA2 region of the thermal interface material 311 may be compressed between the integrated circuit chip 321 and the first support member 211, thereby being brought into closer contact with the integrated circuit chip 321 and/or the first support member 211, and the heat transfer efficiency between the integrated circuit chip 321 and the first support member 211 may be improved.

According to an embodiment, the AA1 region may be pressed in the -Z direction by the shielding film 313 and/or the first support member 211, but there may be no load acting in the +Z direction. For example, in a state in which the thermal interface material 311 is disposed between the first support member 211 and the printed circuit board 240, at least a portion of the AA1 region may move or deform toward the printed circuit board 240, closer than the AA2 region. A distance difference between the printed circuit board 240 and the AA1 region and between the printed circuit board 240 and the AA2 region may substantially correspond to the thickness of the shielding film 313.

According to an embodiment, although a structure in which the shielding film 313 and/or the shield can 249 does not include openings 317a and 317b may provide a more stable electromagnetic shielding structure, the thermal interface material 311 may not be in direct contact with either the integrated circuit chip 321 or the first support member 211, resulting in reduced heat transfer efficiency. In an embodiment, compared with a structure in which the thermal interface material 311 is not in direct contact with either the integrated circuit chip 321 or the first support member 211, it was confirmed that the operating temperature of the processor 321a (e.g., the integrated circuit chip 321) in the electronic device according to one or more embodiments of the disclosure decreased by about 2.5 °C. For example, by providing the openings 317a and 317b in the shielding film 313 and/or the shield can 249 so that the thermal interface material 311 is in direct contact with the integrated circuit chip 321 and/or the first support member 211, the operating environment of one or more electrical components such as the processor 321a may be improved.

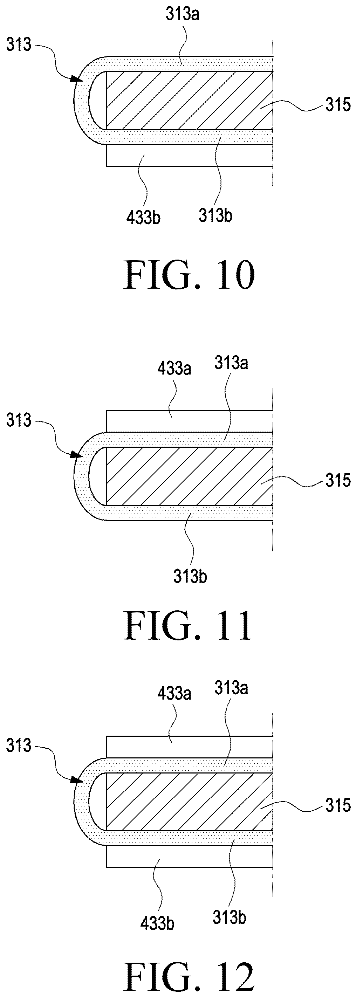

FIGS. 10 to 13 are views illustrating one or more configurations in which adhesives 433a, 433b, 533a, and 533b are provided on a shielding film 313 in a heat dissipation structure 300 of an electronic device 200 according to an embodiment of the disclosure.

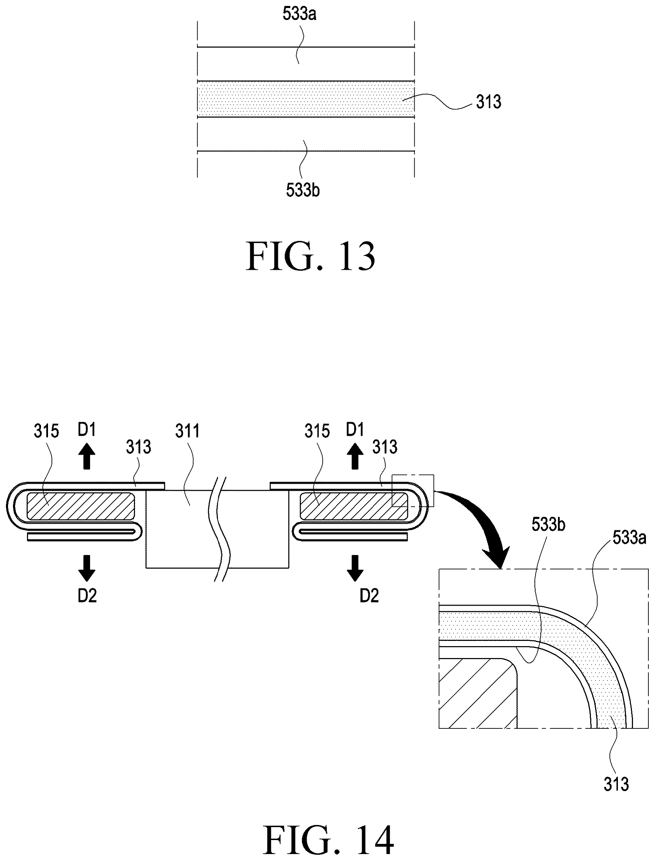

Referring to FIGS. 10 to 13, the electronic device 200 may include one or more adhesives 433a, 433b, 533a, and 533b provided on at least one surface of the shielding film 313. When the shielding film 313 is electrically connected to the first support member 211 and/or the shield can 249, electrically conductive particles may be added to a first adhesive 433a or 533a and/or a second adhesive 433b or 533b. For example, the first adhesive 433a or 533a and/or the second adhesive 433b or 533b may provide an electrical connection structure between the shielding film 313 and the first support member 211 and/or between the shielding film 313 and the shield can 249. In the embodiments of FIGS. 11 and 12, each of the adhesives 433a and 433b may be provided on one surface of the shielding film 313 and may be classified as the first adhesive 433a and the second adhesive 433b according to their provided positions or regions. For example, the first adhesive 433a may attach the shielding film 313 to the first support member 211, and the second adhesive 433b may attach the shielding film 313 to the shield can 249. FIG. 13 illustrates an embodiment in which the adhesives 533a and 533b may include a third adhesive 533a provided on one surface of the shielding film 313 and a fourth adhesive 533b provided on the other surface of the shielding film 313. The third adhesive 533a and the fourth adhesive 533b may attach the shielding film 313 to a corresponding one of the first support member 211 and/or the shield can 249, and one of the third adhesive 533a and the fourth adhesive 533b may attach an elastic member 315 to the shielding film 313.

According to an embodiment, the first adhesive 433a and/or the second adhesive 433b may be provided on at least a portion corresponding to the elastic member 315 and may be provided along a substantially closed-curve trace or a polygonal trace. In an embodiment, the adhesive force between the shielding film 313 and the first support member 211 may be smaller than the adhesive force between the shielding film 313 and the shield can 249. For example, the shielding film 313 and/or the thermal interface material 311 may be attached to the printed circuit board 240 first and then assembled with the first support member 211, and when disassembled for repair or component replacement, the shielding film 313 may be separated from the first support member 211 while remaining attached to the shield can 249.

According to an embodiment, when the elastic member 315 wrapped with the shielding film 313 is provided, an adhesive may not be provided between the shielding film 313 and the first support member 211. For example, when the shielding film 313 and/or the thermal interface material 311 is assembled on the printed circuit board 240 (e.g., on the upper portion of the shield can 249) by the second adhesive 433b, and the shielding film 313 is brought into direct contact or electrical connection with the first support member 211 by receiving an elastic force from the elastic member 315, the first adhesive 433a may be omitted. In an embodiment, the shielding film 313 and/or the thermal interface material 311 may be assembled to the first support member 211, and the second adhesive 433b may be omitted.

According to an embodiment, alignment between the shielding film 313 (e.g., the first opening 317a) and the integrated circuit chip 321, or alignment between the thermal interface material 311 and the integrated circuit chip 321 may be taken into consideration, and the alignment difficulty of the shielding film 313 (or the thermal interface material 311) with respect to the first support member 211 may be relatively low. For example, in the arrangement of the adhesives 433a and 433b or in the sequence of assembling the shielding film 313, the alignment between the shielding film 313 (or the thermal interface material 311) and the integrated circuit chip 321 may be considered first. In an embodiment, when it is desired to omit one of the adhesives 433a and 433b, it may be more preferable to provide the second adhesive 433b and omit the first adhesive 433a.

One of the third adhesive 533a and the fourth adhesive 533b in FIG. 13 may be similar to one of the first adhesive 433a and the second adhesive 433b in FIGS. 10 to 12, and the other of the third adhesive 533a and the fourth adhesive 533b may be similar to the other of the first adhesive 433a and the second adhesive 433b in FIGS. 10 to 12. For example, in a structure in which the third adhesive 533a attaches the shielding film 313 to the first support member 211, the fourth adhesive 533b may attach the shielding film 313 to the shield can 249. Similar to the embodiments of FIGS. 10 to 12, the shielding film 313 may maintain a state of being in direct contact with one of the first support member 211 and the shield can 249 by virtue of an elastic force of the elastic member 315, but may not be directly attached thereto.

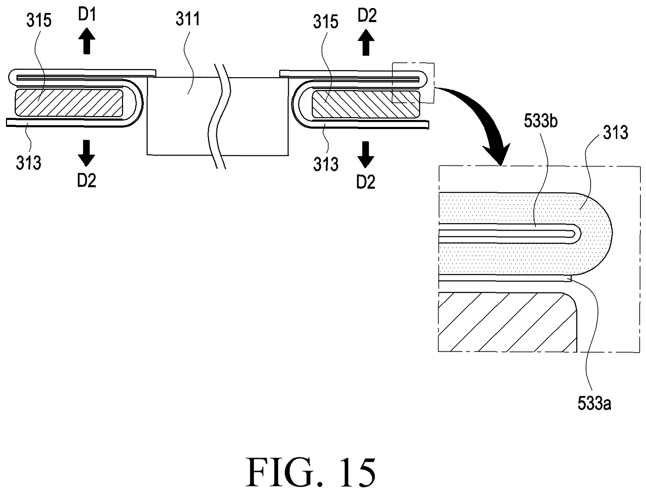

According to an embodiment, the elastic member 315 that brings the shielding film 313 into close contact with the first support member 211 and/or the shield can 249 may be a low-density elastic element, such as a sponge. For example, the elastic member 315 may be freely deformable depending on its own weight or external force. One of the third adhesive 533a and the fourth adhesive 533b may attach the elastic member 315 to the shielding film 313 in a defined state, for example, in a closed-curve shape or a polygonal shape. An embodiment in which the third adhesive 533a and the fourth adhesive 533b are provided on different surfaces of the shielding film 313 will be described in more detail with reference to FIGS. 14 and 15.

FIGS. 14 and 15 are views illustrating one or more configuration in which the shielding film 313 is disposed in a heat dissipation structure 300 of an electronic device 200 according to an embodiment of the disclosure.

Referring further to FIGS. 14 and 15, the electronic device 200 may include a third adhesive 533a and a fourth adhesive 533b provided on different surfaces of the shielding film 313. In an embodiment, when the adhesives 533a and 533b are provided on both surfaces of the shielding film 313, an upper or lower surface of an elastic member 315 may be substantially attached to the shielding film 313. In an embodiment, when the upper or lower surface of the elastic member 315 is substantially attached to the shielding film 313, the shielding film 313 may be folded such that different portions thereof overlap each other at a lower region of the elastic member 315 (e.g., the region oriented in the D2 direction toward the shield can 249) or an upper region of the elastic member 315 (e.g., the region oriented in the D1 direction toward the first support member 211). For example, in a configuration in which the adhesives 533a and 533b are provided on both surfaces of the shielding film 313, different portions of the shielding film 313 may be bonded to face each other by the third adhesive 533a or the fourth adhesive 533b.

In an embodiment illustrated in FIG. 14, the third adhesive 533a may bond two different portions of the shielding film 313 to each other beneath the elastic member 315 while attaching the shielding film 313 to the first support member 211. In an embodiment, when the third adhesive 533a bonds the two different portions of the shielding film 313 to each other, the fourth adhesive 533b may attach the shielding film 313 to the shield can 249 while attaching the elastic member 315 to the shielding film 313. In the embodiment illustrated in FIG. 15, the fourth adhesive 533b may bond two different portions of the shielding film 313 to each other while attaching the shielding film 313 to the shield can 249. In an embodiment, when the fourth adhesive 533b bonds the two different portions of the shielding film 313 to each other, the third adhesive 533a may attach the shielding film 313 to the first support member 211 while attaching the elastic member 315 to the shielding film 313. As previously described with reference to the embodiments of FIGS. 10 to 12, the shielding film 313 may be attached to one of the first support member 211 and the shield can 249 while not being attached to the other. According to an embodiment illustrated in FIG. 15, the third adhesive 533a may be partially omitted, and the shielding film 313 may be in contact with the first support member 211 without being attached thereto.

It will be readily understood by those ordinarily skilled in the art that the foregoing descriptions regarding the configurations of the adhesives 433a, 433b, 533a, and 533b do not limit one or more embodiments of the disclosure, and additional embodiments may be implemented by selectively combining the configurations described in the embodiments of FIGS. 10 to 15.

As described above, an electronic device according to one or more embodiments of the disclosure may include a thermal interface material disposed in direct contact with both the integrated circuit chip and the first support member, thereby rapidly transferring, dispersing, and/or dissipating heat generated from the integrated circuit chip. For example, various electrical components inside the electronic device may be provided with a stable operating environment. In an embodiment, the shielding film (and/or the shield can) may further stabilize the operating environments of electrical components such as a processor, a communication module, and/or memory by implementing an electromagnetic shielding structure while providing a placement structure for the thermal interface material.

The effects capable of being obtained by the disclosure are not limited to those described above, and other effects not described above may be clearly understood by a person ordinarily skilled in the art to which the disclosure belongs from the descriptions of the above-described embodiments.

As described above, an electronic device (e.g., the electronic device 1001, 1002, 1004, 100, or 200 of FIGS. 1 to 5) according to an embodiment of the disclosure includes a first support member (e.g., the first support member 211 of FIG. 4 or FIG. 5) that at least partially includes a thermally conductive material, a printed circuit board (e.g., the printed circuit board 240 of FIG. 4, FIG. 5, or FIG. 6) disposed to face the first support member, an integrated circuit chip (e.g., the integrated circuit chip 321 of FIG. 6) disposed on one surface of the printed circuit board between the first support member and the printed circuit board, the integrated circuit chip being provided with a processor (e.g., the processors 1020 and 321a of FIG. 1 or FIG. 6), a compressible solid-state thermal interface material (TIM) (e.g., the contact type thermal interface material 311 of FIG. 6), which has at least a portion of one surface in contact with the integrated circuit chip (e.g., the region indicated by "AA2" in FIG. 8) and at least a portion of the other surface in contact with the first support member (e.g., the region indicated by "AA1" in FIG. 8), the thermal interface material being configured to transfer heat between the integrated circuit chip and the first support member, and a shielding film (e.g., the shielding film 313 of FIGS. 6 to 8) that is partially disposed between the thermal interface material and the first support member, attached to the thermal interface material, and provides a first opening (e.g., the first opening 317a of FIG. 7 or FIG. 8) configured to allow a portion of the opposite surface of the thermal interface material to be attached to the first support member. In an embodiment, the thermal interface material includes a first portion in contact with the integrated circuit chip and a second portion laterally protruding from the first portion. In an embodiment, the second portion is at least partially attached to the shielding film. For example, the portion of the thermal interface material attached to the shielding film is at least partially disposed around a portion of the thermal interface material that is in contact with the integrated circuit chip.

According to an embodiment, the portion of the thermal interface material attached to the shielding film may be at least partially disposed closer to the printed circuit board than a portion of the thermal interface material that is in contact with the integrated circuit chip.

According to an embodiment, at least a portion of one surface of the shielding film may be attached to the first support member.

According to an embodiment, at least a portion of the one surface of the shielding film may be attached to the first support member along a closed-curve trace or a polygonal trace surrounding the first opening.

According to an embodiment, the shielding film may be electrically connected to the first support member.

According to an embodiment, the electronic device as described above may further include a shield can (e.g., the shield can 249 of FIG. 4 or FIG. 6) disposed to surround at least a portion of the integrated circuit chip and/or providing a second opening (e.g., the second opening 317b of FIG. 6) larger than the first opening. In an embodiment, at least a portion of the thermal interface material may be in contact with the integrated circuit chip inside the shield can through the second opening.

According to an embodiment, at least a portion of an edge of the shielding film may be attached to the shield can around the second opening.

According to an embodiment, at least a portion of an edge of the shielding film may be attached to the shield can along a closed-curve trace or a polygonal trace surrounding the second opening.

In an embodiment, the shielding film may be electrically connected to the shield can.

According to an embodiment, the electronic device as described above may further include an elastic member (e.g., the elastic member 315 of FIG. 6 or FIG. 7) provided on at least a portion of a periphery of the second opening on the shield can. In an embodiment, the shielding film may be disposed to surround at least a portion of the elastic member.

According to an embodiment, a portion of the shielding film may be attached to the first support member, and/or in an embodiment, another portion of the shielding film may be attached to the shield can around the second opening.

According to an embodiment, an adhesive force between the shielding film and the first support member may be smaller than an adhesive force between the shielding film and the shield can.

According to an embodiment, the electronic device as described above may further include a heat pipe or a vapor chamber (e.g., the heat pipe or vapor chamber 319 of FIG. 6 or FIG. 9) disposed on the first support member. In an embodiment, the heat pipe or the vapor chamber may be configured to absorb, transfer, disperse, or release heat from the integrated circuit chip through the thermal interface material.

According to an embodiment, the integrated circuit chip may further include memory (e.g., the memory 1030 or 321b of FIG. 1 or FIG. 6) disposed between the processor and the thermal interface material. In an embodiment, the thermal interface material may be in contact with the memory.

According to an embodiment of the disclosure, an electronic device (e.g., the electronic device 1001, 1002, 1004, 100, or 200 of FIGS. 1 to 5) includes a housing (e.g., the housings 110 and 201 of FIGS. 2 to 5) including a first surface (e.g., the first surface 110A of FIG. 2) and a second surface (e.g., the second surface 110B of FIG. 3) facing in an opposite direction to the first surface, a first support member (e.g., the first support member 211 of FIGS. 4 to 6) accommodated in a space between the first and second surfaces and at least partially including a thermally conductive material, a display (e.g., the display 230 or display panel 231 of FIGS. 4 to 6) disposed between the first surface and the first support member, a printed circuit board (e.g., the printed circuit board 240 of FIGS. 4 to 6) disposed between the second surface and the first support member, an integrated circuit chip (e.g., the integrated circuit chip 321 of FIG. 6) disposed on one surface of the printed circuit board between the first support member and the printed circuit board, the integrated circuit chip being provided with a processor (e.g., the processors 1020 and 321a of FIGS. 1 or 6) and a memory (e.g., the memories 1030 and 321b of FIGS. 1 or 6), a compressible solid-state thermal interface material (e.g., the thermal interface material 311 of FIG. 6) having at least a portion of one surface in contact with the integrated circuit chip and at least a portion of the other surface in contact with the first support member, the thermal interface material being configured to transfer heat between the processor and the first support member or between the memory and the first support member, and a shielding film (e.g., the shielding film 313 of FIGS. 6 to 8) that is partially attached to the thermal interface material between the thermal interface material and the first support member and, and provides a first opening (e.g., the first opening 317a of FIGS. 6 to 8) configured to allow a portion of the opposite surface of the thermal interface material to be attached to the first support member. In an embodiment, the thermal interface material includes a first portion in contact with the integrated circuit chip and a second portion laterally protruding from the first portion. In an embodiment, the second portion may be at least partially attached to the shielding film.

According to an embodiment, the shielding film may be electrically connected to the first support member.

According to an embodiment, the electronic device as described above may further include a shield can (e.g., the shield can 249 of FIGS. 4 or 6) disposed to surround at least a portion of the integrated circuit chip, and in an embodiment, the shield can may provide a second opening (e.g., the second opening 317b of FIG. 6) larger than the first opening. In an embodiment, at least a portion of the thermal interface material may be in contact with the integrated circuit chip inside the shield can through the second opening.

According to an embodiment, at least a portion of an edge of the shielding film may be attached to the shield can along a closed-curve trace or a polygonal trace surrounding the second opening, so that the shielding film may be electrically connected to the shield can.

According to an embodiment, a portion of the shielding film may be attached to the first support member, and another portion of the shielding film may be attached to the shield can around the second opening. In an embodiment, an adhesive force between the shielding film and the first support member may be smaller than an adhesive force between the shielding film and the shield can.

According to an embodiment, the electronic device as described above may further include a heat pipe or a vapor chamber (e.g., the heat pipe or vapor chamber 319 of FIG. 6 or FIG. 9) disposed on the first support member and configured to absorb, transfer, disperse, or release heat from the integrated circuit chip through the thermal interface material, and a graphite sheet (e.g., the graphite sheet 239 of FIG. 6 or FIG. 9) disposed between the first support member and the display. The graphite sheet may be configured to absorb or disperse heat from at least one of the display, the heat pipe, or the vapor chamber.

Although the disclosure has been described with reference to an embodiment as an example, it is to be understood that the embodiment is intended to be exemplary and is not limiting the disclosure. It will be apparent to those skilled in the art that various changes in form and detail may be made without departing from the overall scope of the disclosure, including the appended claims and their equivalents.

## Claims

1. An electronic device (1001; 1002; 1004; 100; 200) comprising:
a first support member (211) including, at least in part, a thermally conductive material;
a printed circuit board (240) disposed to face the first support member;
an integrated circuit chip (321) disposed on one surface of the printed circuit board between the first support member and the printed circuit board, the integrated circuit chip being provided with a processor (1020; 321a);
a compressible solid-state thermal interface material (TIM) (311) having one surface that is at least partially in contact with the integrated circuit chip and an opposite surface that is at least partially in contact with the first support member, the thermal interface material being configured to transfer heat between the integrated circuit chip and the first support member; and
a shielding film (313) partially disposed between the thermal interface material and the first support member and attached to the thermal interface material and providing a first opening (317a) configured to allow a portion of the opposite surface of the thermal interface material to be attached to the first support member,
wherein the thermal interface material includes a first portion in contact with the integrated circuit chip and a second portion laterally protruding from the first portion, and
wherein the second portion is at least partially attached to the shielding film.

2. The electronic device of claim 1, wherein the portion of the thermal interface material attached to the shielding film is at least partially disposed closer to the printed circuit board than the portion of the thermal interface material in contact with the integrated circuit chip.

3. The electronic device of any one of claims 1 and 2, wherein at least a portion of one surface of the shielding film is attached to the first support member.

4. The electronic device of any one of claims 1 to 3, wherein at least a portion of one surface of the shielding film is attached to the first support member along a closed-curve trace or a polygonal trace surrounding the first opening.

5. The electronic device of any one of claims 1 to 4, wherein the shielding film is electrically connected to the first support member.

6. The electronic device of any one of claims 1 to 5, further comprising:
a shield can (249) disposed to surround at least a portion of the integrated circuit chip and providing a second opening (317b) larger than the first opening,
wherein at least a portion of the thermal interface material is in contact with the integrated circuit chip inside the shield can through the second opening.

7. The electronic device of claim 6, wherein at least a portion of an edge of the shielding film is attached to the shield can around the second opening.

8. The electronic device of any one of claims 6 and 7, wherein at least a portion of an edge of the shielding film is attached to the shield can along a closed-curve trace or a polygonal trace surrounding the second opening.

9. The electronic device of any one of claims 6 to 8, wherein the shielding film is electrically connected to the shield can.

10. The electronic device of any one of claims 6 to 9, further comprising:
an elastic member (315) provided on at least a portion of a periphery of the second opening on the shield can,
wherein the shielding film is disposed to surround at least a portion of the elastic member.

11. The electronic device of any one of claims 6 to 10, wherein a portion of the shielding film is attached to the first support member, and another portion of the shielding film is attached to the shield can around the second opening.

12. The electronic device of claim 11, wherein an adhesive force between the shielding film and the first support member is smaller than an adhesive force between the shielding film and the shield can.

13. The electronic device of any one of claims 1 to 12, further comprising:
a heat pipe or a vapor chamber (319) disposed on the first support member,
wherein the heat pipe or the vapor chamber is configured to absorb, transfer, disperse, or release heat from the integrated circuit chip through the thermal interface material.

14. The electronic device of any one of claims 1 to 13, wherein the integrated circuit chip further includes memory (1030; 321b) disposed between the processor and the thermal interface material, and
the thermal interface material is in contact with the memory.

15. The electronic device of claim 1, further comprising:
a housing (110; 201) including a first surface (110A) and a second surface (110B) facing in an opposite direction to the first surface, the housing being configured to accommodate the first support member in a space between the first and second surfaces and to accommodate the printed circuit board between the second surface and the first support member;
a display (230) disposed between the first surface and the first support member;
a heat pipe or a vapor chamber disposed on the first support member and configured to absorb, transfer, disperse, or release heat from the integrated circuit chip through the thermal interface material; and
a graphite sheet (239) disposed between the first support member and the display,
wherein the graphite sheet is configured to absorb or disperse heat from at least one of the display, the heat pipe, or the vapor chamber.
